# EUROPÄISCHE PATENTSCHRIFT

(11) **EP 1 349 968 B1**
(45) Veröffentlichungstag und Bekanntmachung des Hinweises auf die Patenterteilung: **04.01.2012**
(21) Anmeldenummer: 02702245.8
(22) Anmeldetag: 08.01.2002
(51) Int. Cl.: C23C 16/455

(54) **FLUIDVERTEILUNGSVORRICHTUNG FÜR MEHRERE FLUIDE**
LIQUID DISTRIBUTION UNIT FOR MULTIPLE FLUIDS
UNITE DE REPARATION DE FLUIDE POUR REPARTIR PLUSIEURS COURANTS

(30) Priorität: 09.01.2001 DE 10100670
(43) Veröffentlichungstag der Anmeldung: 08.10.2003
(73) Patentinhaber: Technische Universität Carolo-Wilhelmina zu Braunschweig, 38100 Braunschweig (DE); PerCoTech AG, 38108 Braunschweig (DE)
(72) Erfinder: STADEL, Oliver, 38176 Wendeburg (DE); SCHMIDT, Jürgen, 38102 Braunschweig (DE); KRAUSE, Ulrich, 38102 Braunschweig (DE)
(74) Vertreter: Einsel, Martin
(86) Internationale Anmeldenummer: PCT/EP2002/000097
(87) Internationale Veröffentlichungsnummer: WO 2002/055757

(56) Entgegenhaltungen:
- WO-A1-99/48599
- DE-A- 4 412 541
- DE-C- 4 120 176
- US-A- 4 537 217
- US-A- 5 595 606
- US-A- 6 089 472
- PATENT ABSTRACTS OF JAPAN vol. 011, no. 117 (E-498), 11. April 1987 (1987-04-11) & JP 61 263118 A (SHARP CORP), 21. November 1986 (1986-11-21)

## Beschreibung

Die Erfindung betrifft eine Fluidverteilungsvorrichtung zur getrennten Verteilung von zwei oder mehr unterschiedlichen Fluiden, aufweisend mehrere flächig übereinander geschichtete Fluidverteilungseinheiten, von denen eine Fluidverteilungseinheit zum Verteilen eines Fluidstromes auf mehrere Teilströme dient und mindestens einen Fluideinlass für den zugeführten Fluidstrom, mehrere Fluidauslässe für die Teilströme und mehrere Kanäle aufweist, die den Fluideinlass mit den Fluidauslässen verbindet.

Ein praktischer Anwendungsfall für solche Fluidverteilungsvorrichtungen zur Verteilung von einem Fluid sind Zuführvorrichtungen zum Zuführen eines Gasstromes für eine CVD (Chemical vapor deposition) - Beschichtungsanlage, also eine Beschichtungsanlage mit chemischer Gasphasenabscheidung. Bei CVD-Beschichtungsanlagen wird in der Regel das aufzutragende Material in Form einer chemischen Verbindung, die als Vorläuferverbindung oder Precursor bezeichnet wird, zugeführt. Der Precursor wird als Precursorgas gegebenenfalls zusammen mit einem Trägergas der CVD-Beschichtungsanlage zugeführt, wo er dann mit einem getrennt zugeführten Reaktionsgas zusammentrifft, mit diesem reagiert, und die auf das Substrat aufzutragenden Bestandteile freisetzt.

Um über die gesamte Fläche des Substrates das gewünschte Schichtmaterial in gleichmäßiger chemischer Zusammensetzung und gleichmäßiger Dicke aufzutragen, ist eine möglichst gleichmäßige Zuführung des Precursorgases und vorteilhafterweise auch des Trägergases erwünscht. Hierbei sollen insbesondere die Strömungsgeschwindigkeit, das Strömungsprofil und die Strömungsrichtung sowie die Temperatur der einzelnen Gasströme aus den Gasauslässen möglichst gleich sein. Insbesondere für eine kontinuierliche Beschichtung in einem Endlosverfahren müssen in den Düsen gleiche Bedingungen eingestellt sein.

Nach einem beispielsweise aus der US-PS 5,624,498 und der US-PS 6,086,677 bekannten Verfahren wird der Precursorgasstrom zunächst einem größeren Sammelbehälter, zum Beispiel einem großen Rohr, zugeführt, von dem verschiedene Gasauslässe mit Düsen wegführen. Diese Konzeption wird daher auch als "Gasdusche" (shower head) bezeichnet. Durch Verwendung des großen Sammelbehälters soll ein möglichst gleichmäßiger statischer Druck an den verschiedenen Auslässen des Sammelbehälters gewährleistet werden, so dass in den Gasauslässen gleichmäßige, zueinander weitgehend gleiche Strömungen auftreten.

Problematisch an einer derartigen Zuführeinrichtung ist jedoch, dass auch bei Verwendung eines großen Sammelbehälters unterschiedliche dynamische und statische Druckverhältnisse auftreten können, da die verschiedenen Gasauslässe von dem Gaseinlass des Sammelbehälters unterschiedlich weit entfernt sind. So werden Gasauslässe, die näher an dem Gaseinlass des Sammelbehälters angeordnet sind, eine größere Gasaustrittsgeschwindigkeit aufweisen, als weiter entfernte.

Ungünstig ist auch die relativ lange und darüber hinaus unterschiedliche und schwer vorherzusagende oder zu berechnende Verweildauer (Aufenthaltsdauer) der Gase in der "Gasdusche". Insbesondere kann bei leichter zersetzbaren, empfindlicheren organischen Verbindungen in dem Sammelbehälter eine unerwünschte Zersetzung und gegebenenfalls Abscheidung von Bestandteilen des Precursorgases stattfinden. Bei Verwendung einer derartigen Zuführvorrichtung bei unterschiedlichen Gaszuführraten kann bei höheren Gaszuführraten ein ungleichmäßiges Ausströmprofil über die verschiedenen Düsen und bei geringeren Zuführraten und somit einer noch höheren Verweildauer des Precursors in dem Sammelbehälter eine unerwünschte Zersetzung stattfinden. Problematisch ist weiterhin eine gewünschte Temperierung des Gasstromes in dem Sammelbehälter sowie in den Düsen.

Möglich ist auch eine Regelung des Gasstromes aus den verschiedenen Gasauslässen durch die Steuerung der einzelnen Düsen, die in die jeweiligen Gasauslässe eingesetzt sind. Hierbei können insbesondere Düsen, an denen ein höherer Gasdruck anliegt, mit kleinerem Durchschnittsquerschnitt ausgebildet werden als in Düsen, in denen ein geringerer Gasdruck anliegt. Zwar kann hierdurch eine gewisse Vergleichmäßigung der Ausströmgeschwindigkeit an den verschiedenen Düsen erreicht werden; eine derartige Einstellung ist in der Regel jedoch nur für bestimmte Gaszuführraten, bestimmte Gasaustrittsgeschwindigkeiten und bestimmte Temperaturen möglich. Bei einer Änderung dieser Parameter ist eine entsprechende, aufwendige Verstellung der jeweiligen Düseneinstellung notwendig. Auch kann das Strömungsprofil der einzelnen Gasströme aus den jeweiligen Düsen voneinander unterschiedlich sein, auch wenn die mittlere Austrittsgeschwindigkeit bei allen Düsen gleich ist. Weiterhin sind die Verweilzeiten des Gases von der Gaszufuhr bis zu den einzelnen Düsen unterschiedlich.

Die DE 41 20 176 C1 beschreibt eine Vorrichtung und eine Anlage zum Beschichten von kalottenförmigen Substraten, bei der mehrere unterschiedliche Beschichtungskammern mittels eines Gasleitungssystems aus einem gemeinsamen Gaserzeuger mit Gas versorgt werden. Die Gasleitungen sollen Querschnittflächen und Querschnittformen besitzen, die in Abhängigkeit von ihrer Entfernung von Gaserzeuger im Wesentlichen gleich sind.

Weiterhin kann für eine Vergleichmäßigung des Gasstromes eine Diffusoreinrichtung verwendet werden, die zum Beispiel eine Metallplatte mit gleichmäßigen Löchern aufweist. Bei einer derartigen Diffusoreinrichtung können jedoch Turbulenzen im Gasstrom, längere Verweilzeiten von Teilen des Gasstromes und eine unerwünschte Abscheidung oder vorzeitige Gasphasenreaktionen stattfinden. Eine vergleichbare Konzeption wird zum Beispiel in der US-PS 5,595,606 vorgeschlagen. Dort wird außerdem mit einer Vielzahl von ausgeklügelt angeordneten Heizeinrichtungen versucht, eine gleichmäßige Temperierung zu schaffen und so den Strom besser kontrollieren zu können.

Aus der DE 44 12 541 A1 und der US-PS 5,622,606 ist eine Gaseinlassanordnung bekannt; mit der eine möglichst gleichmäßige Versorgung eines Rezipienten über ein Leitungssystem mit einem Arbeitsgas oder einem reaktiv teilnehmenden Gas erfolgen soll. Diese Anordnung ist insbesondere für physikalische oder chemische Beschichtungsverfahren oder Ätzverfahren vorgesehen. Dabei wird vorgeschlagen, die Verbindung von der Gasquelle zu den Gasaustrittsöffnungen analog dem System eines sogenannten binären Baumes auszubilden, in dem von der Gasquelle beziehungsweise von jeder Verzweigung im Leitungssystem gleich beabstandet zwei nachgeschaltete Verzweigungen gespeist werden.

In der JP 61-263118 und in der WO 99/48599 A1 werden in ähnlicher Form jeweils ein Verteilungssystem mit Leitungen vorgeschlagen, die sich symmetrisch von einer Gaszufuhr mehrfach verzweigen und dabei Wege bilden, die in Form und Länge möglichst gleich sein sollen. Dadurch soll eine gleichmäßige Versorgung mehrerer Austrittsanschlüsse durch Gas aus einer einzigen Quelle in gleichmäßiger Form sichergestellt werden, wobei dieses Gas im erstgenannten Fall einem Reaktionsraum in einem Vakuumbehälter zugeführt wird.

Ein weiterer Vorschlag ist aus der US-PS 4,537,217 bekannt, die einen Verteilerkörper für eine Fluidverteilungseinrichtung zeigt, die insbesondere für eine chromatographische Anwendung vorgesehen ist und einen im Wesentlichen gleichmäßigen Fluidstrom zu jeder Verteileröffnung anstrebt.

In wenigen Fällen, beispielsweise in der US-PS 5,595,606, ist auch schon eine Verteilung für zwei separat zu verteilende Fluide angedeutet. Dabei findet innerhalb einer ersten Fluidverteilungseinheit die Verteilung der Fluide statt, die dann durch einen mittleren und einen unteren Block hindurchgeführt werden.

Der Erfindung liegt demgegenüber die Aufgabe zugrunde, einen gegenüber dem Stand der Technik verbesserte Fluidverteilungsvorrichtung zu schaffen, die mehrere separat zu verteilende Fluide gleichmäßiger verteilen kann.

Diese Aufgabe bei einer gattungsgemäßen Fluidverteilungsvorrichtung mit der Erfindung dadurch gelöst, dass jede Fluidverteilungseinheit zum Verteilen jeweils eines der Fluide ausgebildet ist, dass in jeder Fluidverteilungseinheit das oder die jeweils anderen Fluide durch Durchführungen unverteilt geleitet sind, dass die Kanäle sich jeweils in Verzweigungen symmetrisch in nachgeordnete Kanäle aufteilen, dass jede Verbindung von dem Fluideinlass zu einem der Fluidauslässe gleiche Kanäle und gleiche Verzweigungen aufweist, und dass die Kanäle und die Verzweigungen in einer Ebene senkrecht zur Auslassrichtung der Fluidauslässe liegen.

Die Unteransprüche beschreiben bevorzugte Ausführungsformen.

Fluide können dabei Flüssigkeiten oder aber auch Gase oder Gasgemische sein. Die erfindungsgemäßen Fluidverteilungseinheiten bzw. -vorrichtungen können also nicht nur Einsatz finden für die Zufuhr von ein oder mehreren Gasen (Precursorgas mit oder ohne Trägergas, Reaktivgas), sondern auch für die Verteilung von gänzlich anders gearteten Gasen oder Gasgemischen oder Flüssigkeiten, die beispielsweise in eine Reaktionskammer möglichst gleichmäßig und präzise und/oder vorhersagbar geführt werden sollen.

Durch die Erfindung wird eine Fluidverteilungsvorrichtung geschaffen, die einen modularen Aufbau, vorzugsweise mit einzeln auswechselbaren Platten gewährleistet.

Hierbei kann insbesondere auch eine kontinuierliche CVD-Beschichtung in einem Endlosverfahren gewährleistet werden, bei der z.B. auch empfindliche Precursoren für beispielsweise YBaCuO-Hochtemperatursupraleiter verwendet werden.

In einer besonders bevorzugten Ausführungsform sind die Fluidauslässe der verschiedenen Fluide alternierend nebeneinander angeordnet, vorzugsweise entlang einer Geraden. Dann können beispielsweise bei Beschichtungen Multischichten in einem einfachen technischen kontinuierlichen Prozess hergestellt werden. Es kann zum Beispiel mit zwei Precursorgasplatten ein Multischichtsystem aus zwei Materialkomponenten kontinuierlich hergestellt werden.

In bestimmten Fällen kann es sinnvoll sein, für die Verteilung eines Fluides auch mehrere, dann einander nachgeschaltete Fluidverteilungseinheiten einzusetzen, also bevorzugt durch geeignetes Zusammenschalten mehrerer Platten.

Mit der Erfindung wird es bei den erwähnten CVD-Beschichtungsanlagen erreicht, dass insbesondere gleiche Ausströmbedingungen des Gasstromes an den Gasauslässen gewährleistet sind. Hierbei sind vorteilhafterweise die Ausströmgeschwindigkeit, Ausströmrichtung und Temperatur des Gasstromes in den Gasauslässen gleich. Vorteilhafterweise gilt dies sowohl für einen Precursorgasstrom als auch für einen Trägergasstrom. Die erfindungsgemäße Fluidverteilungseinheit ist bei einem Einsatz als Zuführvorrichtung für CVD-Beschichtungsanlagen insbesondere auch relativ kostengünstig herstellbar. Die Verwendung auch empfindlicher Precursoren, zum Beispiel für Hochtemperatursupraleiter, kann in einem Endlosverfahren gewährleistet werden, ohne dass es zu einer unerwünschten Abscheidung kommt.

Gleiche Verzweigungen der jeweiligen Kanäle in jeweils nachfolgende Kanäle sind hierbei auch Verzweigungen, bei denen der Fluidstrom in verschiedene Richtungen, zum Beispiel links und rechts, geführt wird, da die hydrodynamischen Strömungsverhältnisse gleich sind. Dies können insbesondere T-förmige Verzweigungen sein, bei denen der Fluidstrom unter rechten Winkeln in zwei zueinander entgegengesetzte Richtungen weitergeleitet wird.

Der Erfindung liegt der Gedanke zugrunde, ohne eine Zwischenspeicherung des Fluidstromes möglichst symmetrische Verzweigungen von Fluidkanälen für jeden Teilstrom vom Fluideinlass zu einem der Fluidauslässe und hierdurch gleichmäßigen Bedingungen zu schaffen. Erfindungsgemäß werden somit symmetrische Verzweigungen verwendet, die zu jeweils gleichen nachgeordneten Kanälen beziehungsweise Unterkanälen führen, die sich entsprechend wiederum symmetrisch in nachgeordnete Kanäle verzweigen, bis eine hinreichende Verzweigung zu der gewünschten Anzahl von Fluidauslässen erreicht ist. Somit erfolgen Druckänderungen vom Übergang von Kanälen in nachgeordnete Kanäle in sämtlichen Zweigen gleichmäßig, so dass die Verweildauer der Teilströme in den jeweiligen Kanälen beziehungsweise nachgeordneten Kanälen ebenfalls jeweils gleich ist.

Die Kanäle und Verzweigungen können bevorzugt in einer Ebene ausgebildet werden, so dass eine ebene Struktur von Kanälen, Verzweigungen und nachgeordneten Kanälen gebildet wird, die mäanderartige Verläufe der einzelnen Teilströme bewirkt. Die Kanäle, Verzweigungen und nachgeordneten Kanäle können somit in einer Platte, insbesondere aus einem Material mit guter Wärmeleitfähigkeit, zum Beispiel einem Metall wie Aluminium, Kupfer, Messing oder Stahl, gebildet werden. Hierdurch kann bei einer entsprechenden Temperierung der Metallplatte eine gleichmäßige Temperatur in den einzelnen Kanälen, Verzweigungen und Düsen gewährleistet werden.

Die Kanäle können zum Beispiel als Nuten in einer Metallplatte ausgebildet werden, die durch eine angrenzende Platte bis auf den Fluideinlass und die Fluidauslässe abgedeckt und abgedichtet werden. Somit ist eine relativ kostengünstige Herstellung möglich, ohne hierzu zum Beispiel einzelne Metallrohre in jeweils gleicher Stellung zueinander verschweißen zu müssen.

Bei einer Fluidverteilungsvorrichtung für mehrere getrennt zu führende und getrennt zu verteilende Fluide, zum Beispiel ein Precursorgas mit oder ohne Trägergas und ein Reaktivgas, kann jeweils eine Metallplatte für die Verteilung eines ersten Fluides und eine weitere Metallplatte für die Verteilung des anderen Fluides verwendet werden, bei denen zumindest die Kanäle einer Platte von der anderen abgedeckt werden. Weiterhin können zum Beispiel die Kanäle der als Platte ausgebildeten zweiten Fluidverteilungseinheit durch eine nachfolgend aufgesetzte Temperiervorrichtung verdeckt werden, in der Temperierkanäle zur Temperierung ausgebildet sind.

Somit ist ein kompakter Aufbau einer erfindungsgemäßen Fluidverteilungsvorrichtung für mehrere unterschiedliche Fluide möglich, beispielsweise für eine CVD-Beschichtungsanlage, in der lediglich ein Precursorgas oder ein Precursorgas und ein Trägergas neben einem Reaktivgas verwendet wird.

Bei einer Ausbildung mit Verzweigungen der Kanäle in jeweils zwei gleichartige Kanäle wird vorteilhafterweise eine Ausbildung einer Fluidverteilungseinheit mit einer Anzahl von Fluidauslässen erreicht, die eine Zweierpotenz bilden, zum Beispiel 8, 16 oder 32 Fluidauslässen.

Mit der erfindungsgemäßen Fluidverteilungseinheit können problemlos unterschiedliche Fluidzuführraten und somit Fluidaustrittsraten erreicht werden, da hierdurch lediglich die Geschwindigkeiten der Fluidströme in den Kanälen beziehungsweise nachgeordneten Kanälen entsprechend erhöht werden, ohne dass es bei den unterschiedlichen Zuführraten zu unerwünschten Strömungseffekten, wie sie bei herkömmlichen Sammelbehältern auftreten, kommt. Da der Fluidstrom stetig durch die Kanäle und jeweils nachgeordneten Kanäle fließt, kann weiterhin eine Zersetzung und Abscheidung vermieden werden.

Bevorzugt sind der Druckgradient entlang eines jeden Kanals nahezu konstant oder die Strömungswiderstände zwischen den Verzweigungen sind dahezu gleich. Es fehlt also an einem lokalen hohen Strömungswiderstand, der in einem Teilbereich der Fluidverteilungseinheit einen entsprechend hohen Druckabfall verursachen könnte. Auf diese Weise wird gefördert, mit einer minimalen Aufenthaltszeit des Fluides in der Fluidverteilungseinheit eine gleichmäßige Verteilung zu erreichen.

Die Erfindung wird im Folgenden anhand der beiliegenden Zeichnungen an einigen Beispielen näher erläutert. Es zeigen:
- **Figur 1**: eine Draufsicht auf eine Ausführungsform einer erfindungsgemäßen Fluidverteilungsvorrichtung in explodierter Darstellung in drei Teilelementen, nämlich
- **Figur 1a**: eine erste erfindungsgemäße Fluidverteilungseinheit für ein erstes Fluid;
- **Figur 1b**: eine zweite erfindungsgemäße Fluidverteilungseinheit für ein zweites Fluid;
- **Figur 1c**: eine Temperiervorrichtung;
- **Figur 2**: eine übereinandergelegte, also nicht explodierte Darstellung der Ausführungsform aus Figur 1;
- **Figur 3**: einen Längsschnitt durch die Ausführungsform in Figur 1 und 2;
- **Figur 4**: eine andere Ausführungsform einer Fluidverteilungsvorrichtung gemäß der Erfindung mit zwei Teilelementen, nämlich
- **Figur 4a**: eine andere erste erfindungsgemäße Fluidverteilungseinheit für ein erstes Fluid;
- **Figur 4b**: eine andere zweite erfindungsgemäße Fluidverteilungseinheit für ein zweites Fluid;
- **Figur 5**: eine Draufsicht auf eine weitere Ausführungsform einer Fluidverteilungseinheit gemäß der Erfindung;
- **Figur 6**: einen Teil eines Schnittes durch die Fluidverteilungsvorrichtung von Figur 1 und 3; und
- **Figur 7**: einen vergrößerten Ausschnitt aus einem Schnitt parallel zur Bildebene durch die Fluidverteilungseinheit von Figur 1b im Bereich eines Fluidauslasses.

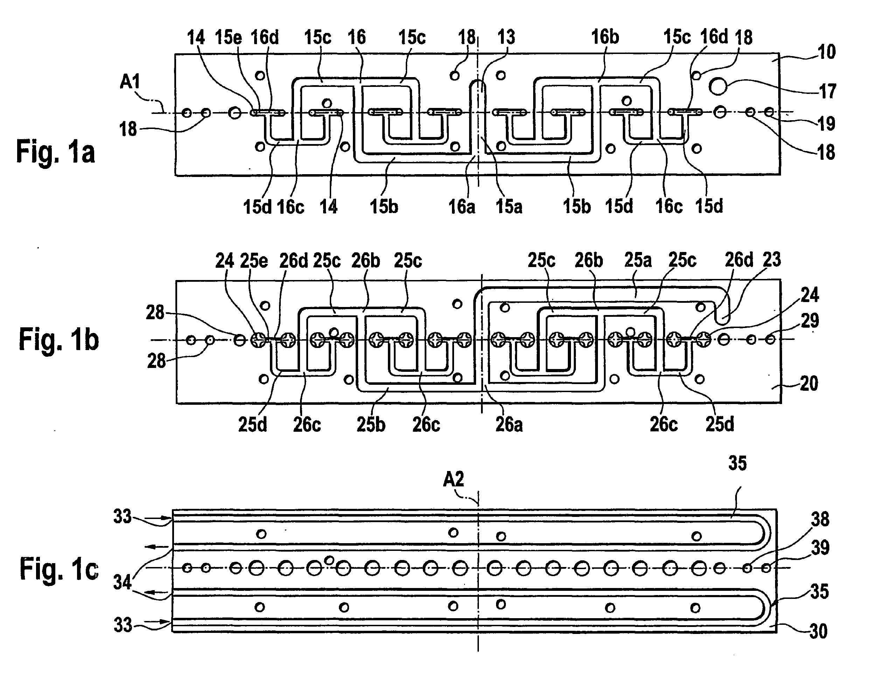

Eine erfindungsgemäße Fluidverteilungsvorrichtung weist gemäß Figur 1 eine erste Fluidverteilungseinheit 10 zur Verteilung eines ersten Fluides, eine zweite Fluidverteilungseinheit 20 zur Verteilung eines zweiten Fluides und eine Temperiervorrichtung 30 zur Zuführung eines Kühl- oder Heizmittels auf. Alle drei Teilelemente sind etwa plattenförmig und jeweils einzeln in den Figuren 1a, 1b und 1c zu erkennen. Als praktisches Beispiel und auch erprobte Ausführung ist dabei eine Zuführvorrichtung für eine CVD-Beschichtungsanlage gewählt worden, wobei dies die Einsatzmöglichkeiten nicht begrenzt. Es wird jedoch im folgenden vorab der Einsatzzweck einer Fluidverteilungsvorrichtung in einer solchen Beschichtungsanlage erläutert:

In einer CVD-Beschichtungsanlage werden zwei Gase getrennt voneinander in einen Reaktions- bzw. Beschichtungsraum geführt. Eines davon ist ein Gasgemisch aus einer Vorläuferverbindung (ein sogenannter Precursor) mit einer Trägerverbindung, die relativ reaktionsträge oder sogar inert ist. Das andere Gas ist ein Reaktionsgas. Treffen Precursor und Reaktionsgas (Prozessgas) aufeinander, reagieren sie und setzen im Precursorgas eine Verbindung frei, die dann unmittelbar zum Beschichten eines Substrates eingesetzt wird, während alle übrigen Reaktionsprodukte und sonstige Bestandteile abgeführt werden.

Der Precursor ist hierbei häufig eine Wasserstoffverbindung (zum Beispiel Silan) oder eine organische Verbindung, etwa bei keramischen Materialien, beispielsweise Hochtemperatursupraleitern, Barium-Strontium-Titanat oder Strontium-Wismut-Tantalat. Das Precursorgas wird in einem Gasstrom auf das erhitzte, zu beschichtende Substrat geleitet. Beim Auftreffen auf das zum Beispiel auf 800 °C erhitzte Substrat zerfällt die chemische Verbindung des Precursors, so dass sich die gewünschten Substanzen, zum Beispiel Silizium oder Yttrium-Barium-Kupfer auf dem Substrat niederschlagen. Zur Herstellung eines keramischen Supraleiters kann zum Beispiel ein geeigneter SauerstoffPartialdruck in dem Beschichtungsraum eingestellt werden, so dass sich Yttrium-Barium-Kupferoxid in der gewünschten Perowskitstruktur mit gewünschter Stöchiometrie einstellt. Zur Erzielung eines geeigneten Gasstromes kann ergänzend ein Trägergas beziehungsweise Spülgas im Gasgemisch mitgeführt werden, das zum Beispiel Sauerstoff als (späteren) Reaktionspartner enthalten kann oder lediglich Gas enthält, das an der chemischen Reaktion zur Erzeugung der gewünschten Beschichtung nicht teilnimmt. Dieses Gasgemisch stellt das erste Fluid dar, das mit einer der Fluidverteilungseinheiten nach der Erfindung verteilt werden kann.

Wie erwähnt kann es Ausführungsformen geben, bei denen nur ein Fluid verteilt werden soll und daher nur eine Fluidverteilungseinheit eingesetzt wird. Dies ist etwa der Fall, wenn allein das Auftreffen auf das 800 °C heiße Substrat für die gewünschte Reaktion des Precursors ausreicht. In sehr vielen Fällen wird jedoch ein weiteres Reaktionsgas eingesetzt, das mit dem Precursor vor der gewünschten Reaktion direkt am Substrat nicht in Berührung kommen darf, und daher getrennt verteilt aber möglichst gleichmäßig und in unmittelbarer Nachbarschaft zu dem Precursor (jetzt also dem ersten Fluid) freigesetzt werden soll. Dieses Reaktions- oder Prozessgas kann auch ein Gasgemisch oder auch eine Flüssigkeit sein und wird jetzt zum zweiten Fluid. Denkbar, aber real selten eingesetzt sind auch dritte Reaktionspartner, die dann als drittes Fluid ähnlich verteilt würden (hier nicht dagestellt).

Die erste Fluidverteilungseinheit 10 in **Figur 1a** ist aus einem Metall, zum Beispiel Aluminium, Kupfer, Messing oder Stahl hergestellt. Sie ist plattenförmig und besitzt eine Oberseite 11 und eine Unterseite 12. In der Oberseite 11 oder der Unterseite 12 der Fluidverteilungseinheit 10 sind verschiedene Kanäle 15 und Verzweigungen 16 als Nuten ausgebildet. Diese Nuten können nachträglich eingefräst oder bereits bei der Herstellung ausgebildet werden.

Im Folgenden wird von einer Ausbildung der gezeigten Struktur auf der Oberseite 11 ausgegangen, die wiederum von einer weiteren plattenförmigen Struktur derartig abgedeckt wird, dass lediglich die Fluidzuführung frei bleibt und von außen angeschlossen werden kann. Alternativ hierzu können die Kanäle und Verzweigungen auch an der Unterseite 12 der plattenförmigen Fluidverteilungseinheit 10 ausgebildet sein und durch die zweite Fluidverteilungseinheit 20 abgedeckt werden.

Ein erster Kanal 15a verläuft in Längsrichtung in einer mittleren Längsposition der Fluidverteilungseinheit 10. An seinem Anfang ist ein Fluideinlass 13 zum Beispiel als durchgängiges Loch ausgebildet, wenn die Fluidzufuhr, also im erörterten Beispiel die Zufuhr des Precursors, von der Oberseite 11 der ersten Fluidverteilungseinheit 10 her erfolgt.

Der erste Kanal 15a endet in Figur 1a unten gezeigt in einer ersten Verzweigung 16a, die T-förmig ausgebildet ist und in rechten Winkeln in zwei zweite Kanäle 15b führt. Die beiden zweiten Kanäle 15b führen jeweils nach einer rechtwinkligen Kurve jeweils zu einer T-förmigen zweiten Verzweigung 16b, die wiederum in je zwei, also insgesamt vier dritte Kanäle 15c überführt. Die dritten Kanäle 15c führen jeweils nach einer rechtwinkligen Kurve über T-förmige, rechtwinklige dritte Verzweigungen 16c zu vierten Kanälen 15d, die entsprechend wiederum jeweils nach einer rechtwinkligen Kurve über T-förmige, rechtwinklige vierte Verzweigungen 16d zu fünften Kanälen 15e führen. Die fünften Kanäle 15e enden nach einer kurzen Strecke jeweils in Fluidauslässen 14.

Die Fluidauslässe 14 liegen hierbei auf einer Geraden, die vorteilhafterweise, wie in Figur 1a gezeigt, die Längsachse der ersten Fluidverteilungseinheit 10 bildet. Wie in Figur 1a gezeigt, sind die beiden ersten Kanäle 15a gleich, das heißt zueinander um die Querachse A2 gespiegelt. Auch die dritten Kanäle 15c und vierten Kanäle 15d sind zueinander gleich beziehungsweise symmetrisch gleich. Die fünften Kanäle 15e sind ebenfalls zueinander gleich und werden lediglich in unterschiedlichen Richtungen durchflossen. Somit ergibt sich ein symmetrisches, vorteilhafterweise um eine Querachse der ersten Fluidverteilungseinheit 10 spiegelsymmetrisches Kanalsystem, bei dem jede Verbindung von dem Fluideinlass 13 zu einem der Fluidauslässe 14 gleiche Kanäle 15, sowie jeweils nachgeordnete Kanäle aufweist, die jeweils gleich, d.h. allenfalls zueinander spiegelsymmetrisch sind. Auch die bei jeder Teilstrecke vorhandenen Verzweigungen 16 sind gleich, das heißt sie unterscheiden sich lediglich in der Richtung der Strömungslenkung. Hierbei werden bei der in Figur 1a gezeigten Draufsicht jedoch bei jeder Verzweigung 16 gleiche Strömungsbedingungen sowohl für den Teilfluidstrom, der bei einer T-förmigen Verzweigung 16 nach links abzweigt, als auch für den entsprechend nach rechts abzweigenden Zweig gewährleistet. Hierbei sind bei der Ausbildung der Kurven in den jeweiligen Kanälen 15 vorteilhafterweise die Abstände der Kurven zu den T-förmigen Verzweigungen 16 jeweils hinreichend groß, so dass aufgrund des hinreichend kleinen Kanalquerschnitts eine gleichmäßige Strömung zu der Verzweigung 16 gelangt, bei der keine Turbulenzen aufgrund der vorherigen Kurve auftreten.

Die erreichten Verbindungen vom Fluideinlass 13 zu den einzelnen Fluidauslässen 14 sind im Vergleich zur tatsächlichen Entfernung relativ lang, um einheitliche Längen der jeweiligen Verbindungen sowie einheitliche geometrische Ausbildungen zu gewährleistet. Die Verlängerung des Transportweges des Fluidstromes wird erfindungsgemäß jedoch in Kauf genommen, um bei jeder Verbindung gleichmäßige Bedingungen zu erreichen. Indem die Fluidverteilungseinheiten 10, 20 wie in den Figuren 1a, 1b gezeigt mit Kanälen 15 in einer Metallplatte ausgebildet werden, kann auch für den relativ langen Weg eine gute Temperierung und somit Einstellung einer gleichmäßigen Temperatur gewährleistet werden. Indem erfindungsgemäß ein durchgängiges Kanalsystem ausgebildet wird, kann hierbei bei entsprechender Temperierung ein stetiger Fluidstrom gewährleistet werden, so dass Ablagerungen an den Kanalwänden - anders als bei den Zwischenbehältern des Standes der Technik - weitgehend vermieden werden können.

Somit wird eine mäanderartige, ineinandergeschachtelte Struktur erreicht, bei der aufgrund der vier Verzweigungen 2⁴, also sechzehn Fluidauslässe 14 gleichmäßig mit dem ersten Fluid, also etwa einem Precursorgas oder einem Gasgemisch versorgt werden können. Gemäß Figur 1a sind die Fluidauslässe 14 entlang der Längsachse A1 gleichmäßig beabstandet.

Wie in **Figur 1b** zu erkennen sind die Kanäle in der zweiten Fluidverteilungseinheit 20 entsprechend ausgebildet. Die Zufuhr des zweiten Fluides (im diskutierten Beispiel also des Reaktions- oder Prozessgases) erfolgt über eine Durchführung 17 in der erste Fluidverteilungseinheit 10, zu einem Fluideinlass 23 in der zweiten Fluidverteilungseinheit 20. Dann sind Kanäle 25 mit Verzweigungen 26 zu den Fluidauslässen 24 vorgesehen. Ein erster Kanal 25a führt nach zwei rechtwinkligen Kurven entsprechend der zu Figur 1a bereits oben beschriebenen Ausbildung zu einer ersten Verzweigung 26a. Die einzelnen Verbindungen zu den Fluidauslässen 24 führen wiederum über zweite Kanäle 25b, T-förmige zweite Verzweigungen 26b, dritte Kanäle 25c, T-förmige dritte Verzweigungen 26c, vierte Kanäle 25d, T-förmige vierte Verzweigungen 26d, und fünfte Kanäle 25e.

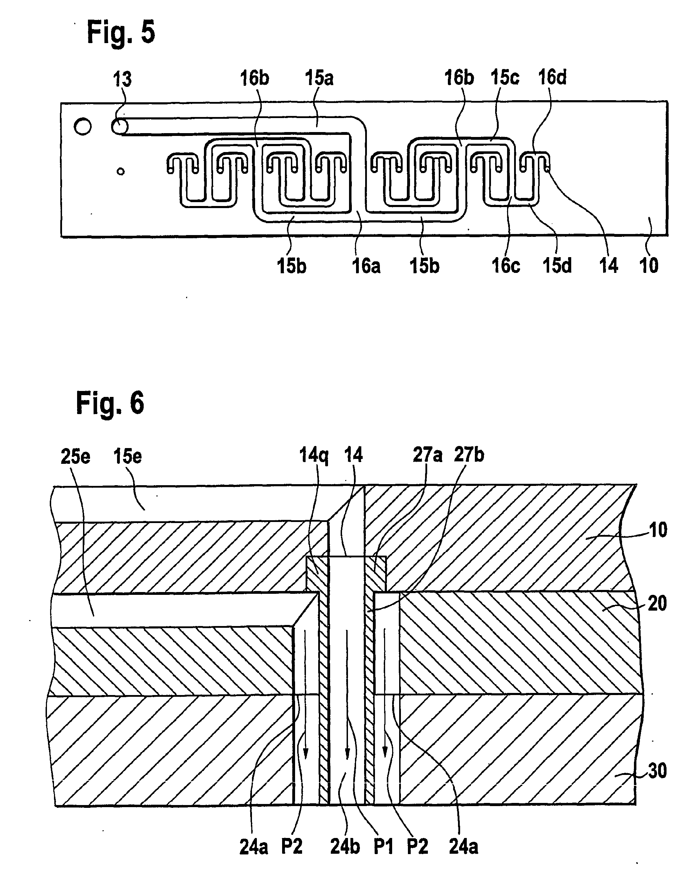

Eine detailliertere Darstellung und Beschreibung des Fluidauslasses 24 und damit auch des Zusammenführens der beiden Fluide ist weiter unten in Zusammenhang mit der Figur 5 angegeben.

**Figur 1c** zeigt unterhalb der zweiten Fluidverteilungseinheit 20 eine ebenfalls plattenförmige Temperiervorrichtung 30 mit einer Oberseite 31 und einer Unterseite 32, in der Temperierkanäle 35 für ein Temperiermedium, d.h. Kühl- und/oder Heizmedium, wie zum Beispiel ein Gas oder eine Flüssigkeit wie Wasser oder Öl, ausgebildet sind. Vorteilhafterweise erfolgt die Temperiermittelzufuhr zu den beiden Temperierkanälen 35 symmetrisch, das heißt wie in Figur 1c gezeigt über äußere Zuführungen zu Temperierkanaleingängen 33, und die Ausgabe des Temperiermittels über innere Temperierkanalausgänge 34, die zwischen den Temperierkanaleingängen 33 liegen, oder umgekehrt,

Die Kanäle 25 und Verzweigungen 26 der zweiten Fluidverteilungseinheit 20 werden durch die nicht gezeigte Unterseite 12 der ersten Fluidverteilungseinheit 10 abgedeckt. Falls alternativ hierzu die Kanäle jeweils an den Unterseiten 12 ausgebildet sind, werden die Kanäle der ersten Fluidverteilungseinheit 10 durch die zweite Fluidverteilungseinheit 20 und die Kanäle der zweiten Fluidverteilungseinheit 20. durch die Temperiervorrichtung 30 abgedeckt, wobei eine weitere Abdeckung für die Temperierkanäle 35 der Temperiervorrichtung 30 vorgesehen ist.

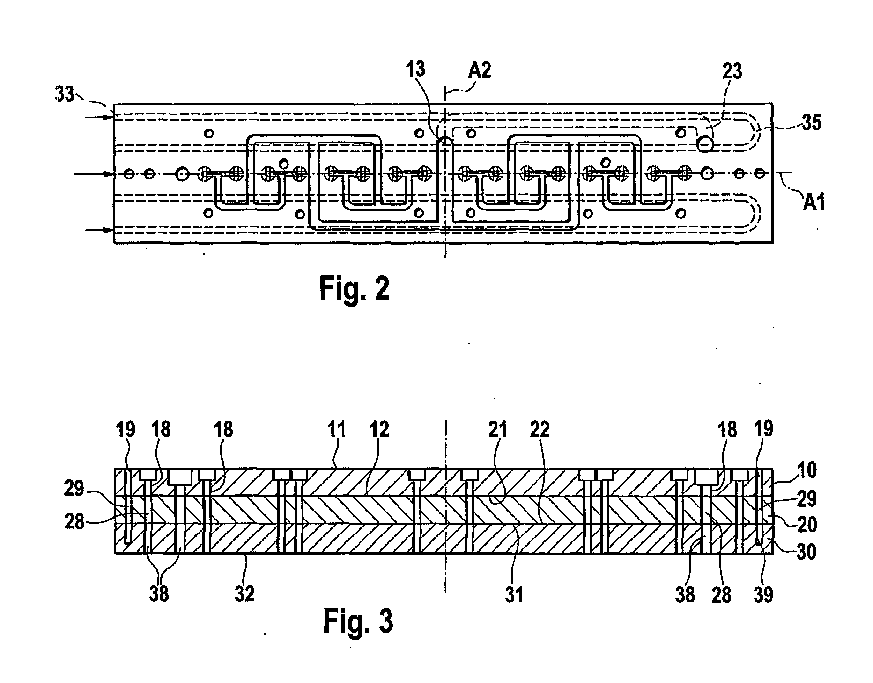

**Figur 2** zeigt übereinandergelegt und in Durchsicht den Verlauf der verschiedenen Kanäle 15, 25, 35 auch relativ zueinander. Gut ist der sich weitgehend überlagernde Aufbau zu erkennen, der eine modulartige Konfiguration verschiedener Fluidverteilungseinheiten 10, 20 wesentlich erleichtert.

Die Platten der Fluidverteilungseinheiten 10 und 20 und die Temperiervorrichtung 30 können gemäß **Figur 3** durch Schrauben verbunden werden, die durch fluchtende Verbindungslöcher 18, 28 und 38 in den Platten geführt werden. Zur Zentrierung können Zentrierstifte in Zentrierbohrungen 19, 29, 39 gesetzt werden.

Die Unterseite 32 der Temperiervorrichtung 30 kann mit einer Beschichtung zur Isolierung beziehungsweise Strahlungsreflexion, zum Beispiel einer Silberschicht versehen werden.

Somit wird ein modularer Aufbau mit relativ einfach auszubildenden Metallplatten ermöglicht, bei denen eine Abdichtung der jeweiligen Kanäle 15, 25, 35 durch die anderen modularen Einheiten erfolgt.

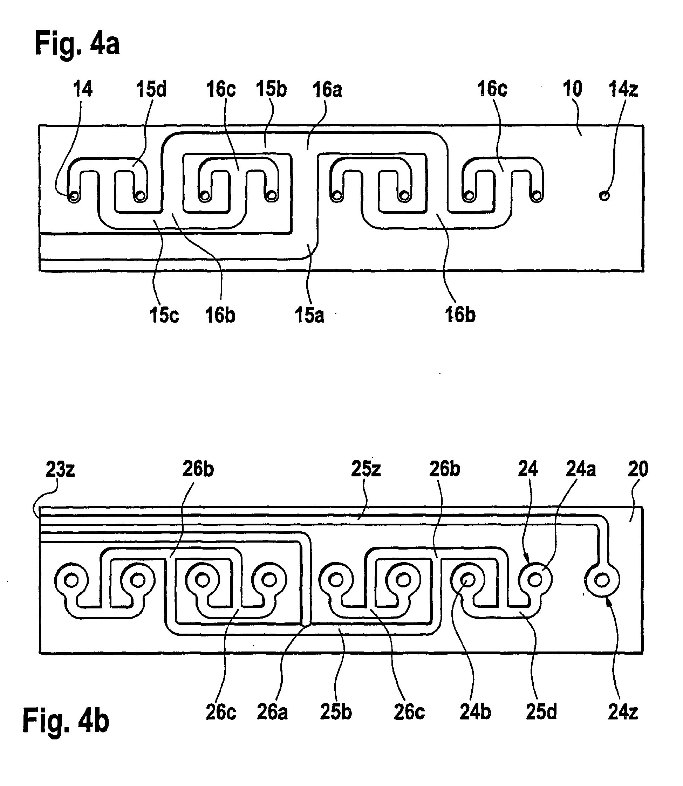

Bei einer anderen Ausführungsform in den **Figur 4** sind in der ersten Fluidverteilungseinheit 10 (**Figur 4a**) lediglich erste, zweite und dritte Verzweigungen 15a, 15b und 15c ausgebildet, so dass lediglich 2³, also acht Fluidauslässe 14 für das erste Fluid mit dem Fluideinlass 13 verbunden sind.

Äquivalentes gilt auch für die zweite Fluidverteilungseinheit 20 (**Figur 4b**). Auch hier sind nur erste, zweite und dritte Verzweigungen 25a, 25b und 25c ausgebildet, so dass lediglich 2³, also acht Fluidauslässe 24 für das zweite Fluid mit dem Fluideinlass 23 verbunden sind.

Angedeutet ist in Figur 4a noch eine separate und nicht mit verteilte Durchführung für ein weiteres Fluid, beispielsweise einen anderen Precursor, der von oben zugeführt und nach unten abgegeben wird. Gemäß Figur 4b ist außerdem am Anfang oder Ende einer Bearbeitungsstraße ein weiterer Fluidauslass 24z vorgesehen, der über einen separaten Kanal 25z mit einem gesonderten Fluideinlass 23z verbunden ist. Dies stellt eine zur Durchführung 14z aus der ersten Fluidverteilungseinheit 20 passende Zuführung von Koaxialgas dar. Mit diesen zusätzlichen Elementen 14z, 23z, 24z, 25z kann in einer CVD-Anlage ein zweites Schichtmaterial auf einem darunter kontinuierlich gezogenen Band abgeschieden werden.

Die Fluidauslässe 24 der zweiten Fluidverteilungseinheit 20 gemäß Figur 4b weisen einen ringförmigen äußeren Bereich 24a zur Ausbildung des Stromes aus zweitem Fluid auf, der einen inneren Bereich 24b umgibt, durch den die Durchführungen 27 für das erste Fluid führen:

Es sind also Durchführungen 27 durch die zweite Fluidverteilungseinheit 20 geführt, die in inneren Bereichen 24b der Fluidauslässe 24 aufgenommen sind und das erste Fluid abgeben, das von der ersten Fluidverteilungseinheit 10 in den Fluidauslässen 14 abgegeben und dann unmittelbar durch diese Durchführungen 27 in der zweiten Fluidverteilungseinheit 20 geleitet werden. Äußere Bereiche 24a dienen der Ausgabe des zweiten Fluides, also beispielsweise des Reaktionsgases, das bis dahin getrennt vom ersten Fluid, also beispielsweise dem Precursorgasstrom, geführt wurde. Es bildet sich nun ein gerichteter Gasstrom aus beiden Fluiden auf das Substrat aus, die bei dieser Bewegung jetzt die gewünschten Reaktionen ausführen und darauf abgestimmt genau beim Substrat abgeschlossen haben können.

**Figur 5** zeigt einen weiteren möglichen Aufbau einer Fluidverteilungseinheit 10 oder 20 mit ersten, zweiten, dritten und vierten Verzweigungen 16 und somit 2⁴, also sechzehn gleichmäßig mit Fluid beschickten Fluidauslässen 14.

Gemäß dem vergrößerten Ausschnitt von **Figur 6** kann der Fluidauslass 14 der Fluidverteilungseinheit 10 von Figur 1a - sowie auch die entsprechenden Fluidauslässe 14 der anderen Ausführungsformen - mit einer Querschnittsvergrößerung 14q an ihrem unteren Ende ausgebildet sein, in die ein Ende 27a der Durchführung 27 eingesetzt wird. Der Schaft 27b der Durchführung 27 erstreckt sich gemäß **Figur 6** durch die Fluidauslässe 24, so dass lediglich ein äußerer Bereich 24a der Fluidauslässe 24 mit zweitem Fluid versorgt wird. Durch den inneren Bereich 24b mit der Durchführung 27 des Fluidauslasses 14 wird somit (in Figur 8 durch einen Pfeil P1 angedeutet) erstes Fluid nach unten geleitet, wohingegen das zweite Fluid gemäß dem Pfeil P2 koaxial außerhalb hierzu geführt wird.

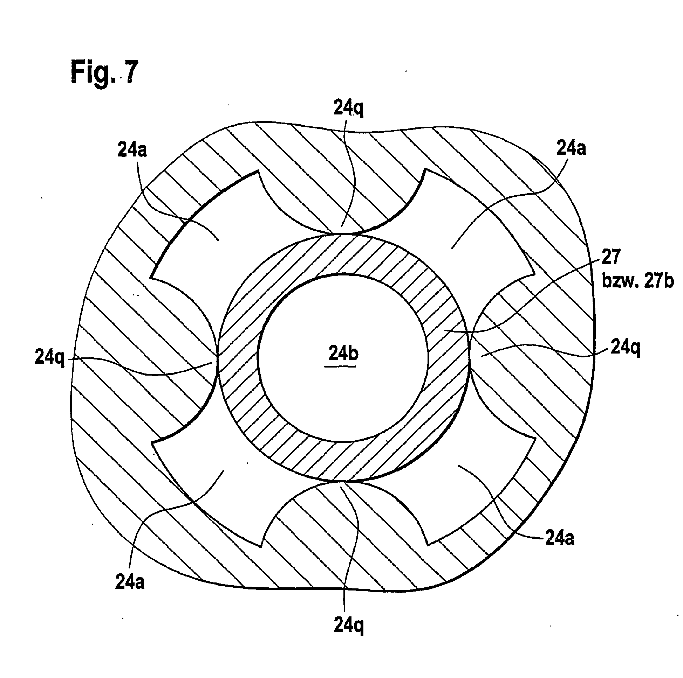

In **Figur 7** ist eine Möglichkeit dargestellt, wie die Durchführung 27 durch Zentriemasen 24q auf der Unterseite 22 der Fluideinheit stabilisiert werden kann.

Alternativ zu den hier gezeigten Ausführungsformen können auch Y-förmige Verzweigungen 16 bzw. 26 in einer Ebene, oder auch nicht in einer Ebene liegende Verzweigungen 16, 26 verwendet werden. Hierbei kann zum Beispiel eine Durchführung des jeweiligen Fluidstromes von der Oberseite 11, 21 zur Unterseite 12, 22 in zum Beispiel drei nachfolgende Kanäle 15, 25 erfolgen.

Auf diese Weise kann ein einzelner Fluideinlass auf eine Anzahl von Fluidauslässen verteilt werden, die ein Produkt aus einer Zweierpotenz und einer Dreierpotenz bilden (zum Beispiel: 2, 3, 4, 6, 8, 9, 12, 16, 18).

### Bezugszeichenliste

- 10: erste Fluidverteilungseinheit
- 11: Oberseite der ersten Fluidverteilungseinheit
- 12: Unterseite der ersten Fluidverteilungseinheit
- 13: Fluideinlass der ersten Fluidverteilungseinheit
- 14: Fluidauslässe der ersten Fluidverteilungseinheit
14q Querschnittserweiterung des Fluidauslasses
14z separate Fluiddurchlass in Ausführungsform nach Figur 4
- 15: Kanäle in der ersten Fluidverteilungseinheit
15a erster Kanal
15b zweiter Kanal
15c dritter Kanal
15d vierter Kanal
15e fünfter Kanal
- 16: Verzweigungen der Kanäle in der ersten Fluidverteilungseinheit
16a erste Verzweigung
16b zweite Verzweigung
16c dritte Verzweigung
16d vierte Verzweigung
- 17: Durchführung für zweites Fluid in erster Fluidverteilungseinheit
- 18: Verbindungslöcher in der ersten Fluidverteilungseinheit
- 19: Zentrierbohrungen in der ersten Fluidverteilungseinheit

- 20: zweite Fluidverteilungseinheit
- 21: Oberseite der zweiten Fluidverteilungseinheit
- 22: Unterseite der zweiten Fluidverteilungseinheit
- 23: Fluideinlass der zweiten Fluidverteilungseinheit
23z zusätzlicher Fluideinlass in Ausführungsform nach Figur 4b
- 24: Fluidauslässe der zweiten Fluidverteilungseinheit
24a äußerer Bereich der Fluidauslässe
24b innerer Bereich der Fluidauslässe
24q Zentriemasen nach Figur 7
24z zusätzlicher Fluidauslass in Ausführungsform nach Figur 4b
- 25: Kanäle in der zweiten Fluidverteilungseinheit
25a erster Kanal
25b zweiter Kanal
25c dritter Kanal
25d vierter Kanal
25e fünfter Kanal
25z zusätzlicher Kanal in Ausführungsform nach Figur 4b
- 26: Verzweigungen der Kanäle in der zweiten Fluidverteilungseinheit
26a erste Verzweigung
26b zweite Verzweigung
26c dritte Verzweigung
26d vierte Verzweigung
- 27: Durchführung
27a Ende der Durchführung
27b Schaft der Durchführung
- 28: Verbindungslöcher in der zweiten Fluidverteilungseinheit
- 29: Zentrierbohrungen in der zweiten Fluidverteilungseinheit

- 30: Temperiervorrichtung
- 31: Oberseite der Temperiervorrichtung
- 32: Unterseite der Temperiervorrichtung
- 33: Temperierkanaleingänge
- 34: Temperierkanalausgänge
- 35: Temperierkanäle
- 38: Verbindungslöcher in der Temperiervorrichtung
- 39: Zentrierbohrungen in der Temperiervorrichtung

- A1: Längsachse der Fluidverteilungseinheit
- A2: Querachse der Fluidverteilungseinheit
- P1: Pfeil für Bewegungsrichtung des ersten Fluids
- P2: Pfeil für Bewegungsrichtung des zweiten Fluids

## Patentansprüche

1. Fluidverteilungsvorrichtung zur getrennten Verteilung von zwei oder mehr unterschiedlichen Fluide,
aufweisend mehrere flächig übereinander geschichtete Fluidverteilungseinheiten (10, 20),
von denen eine Fluidverteilungseinheit (10) zum Verteilen eines Fluidstromes auf mehrere Teilströme dient und mindestens einen Fluideinlass (13) für den zugeführten Fluidstrom, mehrere Fluidauslässe (14, 24) für die Teilströme und mehrere Kanäle (15) aufweist, die den Fluideinlass (13) mit den Fluidauslässen (14) verbindet,
**dadurch gekennzeichnet,**
**dass** jede Fluidverteilungseinheit (10, 20) zum Verteilen jeweils eines der Fluide ausgebildet ist,
**dass** in jeder Fluidverteilungseinheit (10, 20) das oder die jeweils anderen Fluide durch Durchführungen (17, 27) unverteilt geleitet sind,
**dass** die Kanäle (15, 25) sich jeweils in Verzweigungen (16, 26) symmetrisch in nachgeordnete Kanäle (15b, 15c, 15d, 15e; 25b, 25c, 25d, 25e) aufteilen,
**dass** jede Verbindung von dem Fluideinlass (13; 23) zu einem der Fluidauslässe (14; 24) gleiche Kanäle (15, 25) und gleiche Verzweigungen (16, 26) aufweist, und
**dass** die Kanäle (15, 25) und die Verzweigungen (16, 26) in einer Ebene senkrecht zur Auslassrichtung der Fluidauslässe (14, 24) liegen.

2. Fluidverteilungsvorrichtung nach Anspruch 1,
**dadurch gekennzeichnet,**
**dass** jede Fluidverteilungseinheit (10, 20) plattenförmig aufgebaut ist, vorzugsweise aus Metall.

3. Fluidverteilungsvorrichtung nach Anspruch 1 oder 2,
**dadurch gekennzeichnet,**
**dass** die Fluidauslässe (14) für das erste Fluid und die Fluidauslässe (24) für das zweite Fluid oder weitere Fluide konzentrisch zueinander angeordnet sind.

4. Fluidverteilungsvorrichtung nach einem der vorstehenden Ansprüche,
**dadurch gekennzeichnet,**
**dass** eine Temperiervorrichtung (30) zum Kühlen und/oder Heizen unterhalb der mehreren Fluidverteilungseinheiten (10, 20) vorgesehen ist.

5. Fluidverteilungsvorrichtung nach Anspruch 4,
**dadurch gekennzeichnet,**
**dass** die Temperiervorrichtung (30) plattenförmig ist und
**dass** auf einer Unterseite (32) der Temperiervorrichtung (30) eine strahlungsreflektierende Schicht, vorzugsweise eine Silberschicht, vorgesehen ist.

6. Fluidverteilungsvorrichtung nach einem der Ansprüche 4 oder 5,
**dadurch gekennzeichnet,**
**dass** die Fluidverteilungseinheiten (10, 20) und die Temperiervorrichtung (30) fluchtende Befestigungslöcher (18; 28; 38) zur Aufnahme von senkrecht verlaufenden Verbindungsschrauben aufweisen.

7. Fluidverteilungsvorrichtung nach einem der vorstehenden Ansprüche,
**dadurch gekennzeichnet,**
**dass** die Fluidauslässe (14, 24) der verschiedenen Fluide alternierend nebeneinander liegen, vorzugsweise entlang einer Geraden.

8. Fluidverteilungsvorrichtung nach einem der vorstehenden Ansprüche,
**dadurch gekennzeichnet,**
**dass** sie als Zuführeinrichtung von Gasen für eine CVD-Beschichtungsanlage ausgebildet ist,
**dass** mindestens eine Fluidverteilungseinheit (10) für mindestens ein Precursorgas mit gegebenenfalls einem Trägergas vorgesehen ist, und
**dass** mindestens eine Fluidverteilungseinheit (20) für mindestens ein Reaktivgas vorgesehen ist.

9. Fluidverteilungsvorrichtung nach einem der vorstehenden Ansprüche,
**dadurch gekennzeichnet,**
**dass** die Kanäle (15, 25) als Nuten in einer Unterseite (12, 22) oder Oberseite (11, 21) einer der plattenförmigen Fluidverteilungseinheiten (10, 20) ausgebildet und durch eine andere flächig benachbarte plattenförmige Fluidverteilungseinheit (20, 10) oder eine andere plattenförmige Vorrichtung (30) verdeckt sind.

10. Fluidverteilungsvorrichtung nach einem der vorstehenden Ansprüche,
**dadurch gekennzeichnet,**
**dass** sich jeweils ein Kanal (15a, 15b, 15c, 15d; 25a, 25b, 25c, 25d) in einer Verzweigung (16, 26) symmetrisch in mindestens zwei nachgeordnete Kanäle (15b, 15c, 15d, 15e; 25b, 25c, 25d, 25e) verzweigt.

11. Fluidverteilungsvorrichtung nach einem der vorstehenden Ansprüche,
**dadurch gekennzeichnet,**
**dass** die Kanäle (15, 25) sich in den Verzweigungen (16, 26) rechtwinklig, vorzugsweise T-förmig, verzweigen.

12. Fluidverteilungsvorrichtung nach einem der vorstehenden Ansprüche,
**dadurch gekennzeichnet,**
**dass** die Kanäle (15, 25) geradlinige Strecken oder geradlinige Strecken mit rechtwinkligen Kurven aufweisen.

13. Fluidverteilungsvorrichtung nach einem der vorstehenden Ansprüche,
**dadurch gekennzeichnet,**
**dass** die Fluidauslässe (14; 24) auf einer Geraden liegen.

14. Fluidverteilungsvorrichtung nach einem der vorstehenden Ansprüche,
**dadurch gekennzeichnet,**
**dass** der Druckgradient entlang eines Kanals (15, 25) um weniger als ± 20% variiert oder der Strömungswiderstand in den Kanälen (15b, 15c, 15d, 15e, 25b, 25c, 25d, 25e) zwischen den Verzweigungen (16a, 16b, 16c, 16d, 16e, 26a, 26b, 26c, 26d, 26e) um weniger als ± 20% variiert.

## Claims

1. A fluid distribution device for separately distributing two or more different fluids
comprising a plurality of fluid distribution units (10, 20) which are layered in planar manner one above the other,
of which one fluid distribution unit (10) serves for dividing a stream of fluid into a plurality of partial streams and at least one fluid inlet (13) for the incoming stream of fluid, a plurality of fluid outlets (14, 24) for the partial streams, and a plurality of channels (15, 25) which connect the fluid inlet (13; 23) to the fluid outlets (14, 24),
**characterised**
**in that** each fluid distribution unit (10, 20) is configured for distributing a respective one of the fluids,
**in that** in each fluid distribution unit (10, 20) the respective other fluid(s) are fed through ducts (17, 27) in an undistributed manner,
**in that** the channels (15, 25) divide into respective branches (16, 26) in symmetrical manner into succeeding channels (15b, 15c, 15d, 15e; 25b, 25c, 25d, 25e),
**in that** each connection from the fluid inlet (13; 23) to one of the fluid outlets (14; 24) comprises similar channels (15, 25) and similar branches (16, 26), and
**in that** the channels (15, 25) and the branches (16, 26) lie in a plane perpendicular to the outlet direction of the fluid outlets (14, 24).

2. A fluid distribution unit in accordance with Claim 1,
**characterised**
**in that** each fluid distribution unit (10, 20) is of plate-like form, preferably of metal,

3. A fluid distribution device in accordance with Claim 1 or 2,
**characterised**
**in that** the fluid outlets (14) for the first fluid and the fluid outlets (24) for the second fluid or further fluids are mutually concentric.

4. A fluid distribution device in accordance with any of the preceding Claims,
**characterised**
**in that** a temperature controlling device (30) for cooling and/or heating purposes is provided below the plurality of fluid distribution units (10, 20).

5. A fluid distribution device in accordance with Claim 4,
**characterised**
**in that** the temperature controlling device (30) is plate-like and
**in that** a radiation reflecting layer, preferably a silver layer, is provided on a lower surface (32) of the temperature controlling device (30).

6. A fluid distribution device in accordance with either of the Claims 4 or 5,
**characterised**
**in that** the fluid distribution units (10, 20) and the temperature controlling device (30) comprise aligned securing holes (18; 28; 38) for accommodating perpendicularly extending connecting bolts.

7. A fluid distribution device in accordance with any of the preceding Claims,
**characterised**
**in that** the fluid outlets (14, 24) for the different fluids are located adjacent to one another in alternating manner, and preferably lie in a straight line.

8. A fluid distribution device in accordance with any of the preceding Claims,
**characterised**
**in that** it is in the form of a supply device for the gases for a CVD coating plant,
**in that** at least one fluid distribution unit (10) is provided for at least one precursor gas optionally with a carrier gas,
and
**in that** at least one fluid distribution unit (20) is provided for at least one reactive gas.

9. A fluid distribution unit in accordance with any of the preceding Claims,
**characterised**
**in that** the channels (15, 25) are in the form of groves in a lower surface (12, 22) or upper surface (11, 21) of one of the plate-like fluid distribution units (10, 20) and are covered by another planar, adjacent plate-like fluid distribution unit (20, 10) or another plate-like device (30).

10. A fluid distribution unit in accordance with any of the preceding Claims,
**characterised**
**in that** a respective channel (15a, 15b, 15c, 15d; 25a, 25b, 25c, 25d) in a branch (16, 26) branches symmetrically into at least two succeeding channels (15b, 15c, 15d, 15e; 25b, 25c, 25d, 25e).

11. A fluid distribution unit in accordance with any of the preceding Claims,
**characterised**
**in that** the channels (15, 25) branch into the branches (16, 26) at right angles, preferably in the form of a T.

12. A fluid distribution unit in accordance with any of the preceding Claims,
**characterised**
**in that** the channels (15, 25) comprise straight portions or straight portions with right-angled curves.

13. A fluid distribution unit in accordance with any of the preceding Claims,
**characterised**
**in that** the fluid outlets (14; 24) lie in a straight line.

14. A fluid distribution unit in accordance with any of the preceding Claims,
**characterised**
**in that** the pressure gradient along a channel (15, 25) varies by less than ±20% or the flow resistance in the channels (15b, 15c, 15d, 15e; 25b, 25c, 25d, 25e) between the branches (16a, 16b, 16c, 16d, 16e, 26a, 26b, 26c, 26d, 26e) varies by less than ±20%.

## Revendications

1. Dispositif de répartition de fluide pour répartir de manière séparée deux ou plusieurs fluides différents,
présentant plusieurs unités de répartition de fluide (10, 20) superposées de manière plane,
dont une unité de répartition de fluide (10) sert à répartir un courant fluidique sur plusieurs courants partiels et présente au moins une entrée de fluide (13) pour le courant fluidique amené, plusieurs sorties de fluide (14, 24) pour les courants partiels et plusieurs canaux (15) qui relient l'entrée de fluide (13) aux sorties de fluide (14),
**caractérisé en ce que**
chaque unité de répartition de fluide (10, 20) est réalisée pour la répartition respective de l'un des fluides,
le ou les autres fluides respectifs sont conduits sans être répartis dans chaque unité de répartition de fluide (10, 20) par des passages (17, 27),
les canaux (15, 25) se divisent respectivement de manière symétrique en bifurcations (16, 26) dans des canaux subordonnés (15b, 15c, 15d, 15e ; 25b, 25c, 25d, 25e),
chaque liaison de l'entrée de fluide (13 ; 23) à l'une des sorties de fluide (14 ; 24) présente des canaux identiques (15, 25) et des bifurcations identiques (16, 26), et
les canaux (15, 25) et les bifurcations (16, 26) se situent dans un plan perpendiculaire au sens des sorties de fluide (14, 24).

2. Dispositif de répartition de fluide selon la revendication 1,
**caractérisé en ce que**
chaque unité de répartition de fluide (10, 20) présente une forme de plaque, de préférence en métal.

3. Dispositif de répartition de fluide selon la revendication 1 ou 2,
**caractérisé en ce que**
les sorties de fluide (14) pour le premier fluide et les sorties de fluide (24) pour le second fluide ou autres fluides sont disposées de manière concentrique les unes par rapport aux autres.

4. Dispositif de répartition de fluide selon l'une quelconque des revendications précédentes,
**caractérisé en ce**
**qu'**un dispositif d'équilibrage de la température (30) est prévu au-dessous de plusieurs unités de répartition de fluide (10, 20) pour le refroidissement et/ou le chauffage.

5. Dispositif de répartition de fluide selon la revendication 4,
**caractérisé en ce que**
le dispositif d'équilibrage de la température (30) présente une forme de plaque, et **en ce**
**qu'**une couche réfléchissant les rayonnements, de préférence une couche d'argent, est prévue sur un côté inférieur (32) du dispositif d'équilibrage de la température (30).

6. Dispositif de répartition de fluide selon l'une quelconque des revendications 4 ou 5,
**caractérisé en ce que**
les unités de répartition de fluide (10, 20) et le dispositif d'équilibrage de la température (30) présentent des trous de fixation s'alignant (18 ; 28 ; 38) pour la réception de vis de raccordement s'étendant perpendiculairement.

7. Dispositif de répartition de fluide selon l'une quelconque des revendications précédentes,
**caractérisé en ce que**
les sorties (14, 24) des différents fluides se situent en alternance l'une à côté de l'autre, de préférence le long d'une droite.

8. Dispositif de répartition de fluide selon l'une quelconque des revendications précédentes,
**caractérisé en ce qu'**il est réalisé comme un dispositif d'amenée de gaz pour une installation de revêtement CVD, **en ce**
**qu'**au moins une unité de répartition de fluide (10) est prévue pour au moins un gaz précurseur avec éventuellement un gaz porteur, et **en ce**
**qu'**au moins une unité de répartition de fluide (20) est prévue pour au moins un gaz réactif.

9. Dispositif de répartition de fluide selon l'une quelconque des revendications précédentes,
**caractérisé en ce que**
les canaux (15, 25) sont réalisés comme des rainures dans un côté inférieur (12, 22) ou côté supérieur (11, 21) de l'une des unités de répartition de fluide (10, 20) en forme de plaque et sont recouverts par une autre unité de répartition de fluide (20, 10) en forme de plaque contiguë de manière plane ou un autre dispositif (30) en forme de plaque.

10. Dispositif de répartition de fluide selon l'une quelconque des revendications précédentes,
**caractérisé en ce que**
respectivement un canal (15a, 15b, 15c, 15d ; 25a, 25b, 25c, 25d) dans une bifurcation (16, 26) bifurque de manière symétrique dans au moins deux canaux subordonnés (15b, 15c, 15d, 15e ; 25b, 25c, 25d, 25e).

11. Dispositif de répartition de fluide selon l'une quelconque des revendications précédentes,
**caractérisé en ce que**
les canaux (15, 25) bifurquent dans les bifurcations (16, 26) à angle droit, de préférence en T.

12. Dispositif de répartition de fluide selon l'une quelconque des revendications précédentes,
**caractérisé en ce que**
les canaux (15, 25) présentent des parcours linéaires ou des parcours linéaires avec des courbes à angle droit.

13. Dispositif de répartition de fluide selon l'une quelconque des revendications précédentes,
**caractérisé en ce que**
les sorties de fluide (14 ; 24) se situent sur une droite.

14. Dispositif de répartition de fluide selon l'une quelconque des revendications précédentes,
**caractérisé en ce que**
le gradient de pression le long d'un canal (15, 25) varie de moins de ±20 % ou la résistance à l'écoulement dans les canaux (15b, 15c, 15d, 15e, 25b, 25c, 25d, 25e) entre les bifurcations (16a, 16b, 16c, 16d, 16e, 26a, 26b, 26c, 26d, 26e) varie de moins de ±20 %.
